# EUROPEAN PATENT APPLICATION

(11) **EP 4 686 336 A1**
(43) Date of publication of application: **28.01.2026**
(21) Application number: 25181053.7
(22) Date of filing: 05.06.2025
(51) Int. Cl.: H10B 12/00

(54) **SEMICONDUCTOR DEVICES**

(30) Priority: 24.07.2024 KR 20240097807
(71) Applicant: Samsung Electronics Co., Ltd., Suwon-si, Gyeonggi-do 16677 (KR)
(72) Inventor: PARK, Taejin, Suwon-si, Gyeonggi-do 16677 (KR); YIM, Sungsoo, Suwon-si, Gyeonggi-do 16677 (KR); KIM, Suklae, Suwon-si, Gyeonggi-do 16677 (KR); KIM, Cheonbae, Suwon-si, Gyeonggi-do 16677 (KR); KIM, Taejin, Suwon-si, Gyeonggi-do 16677 (KR); JANG, Yoona, Suwon-si, Gyeonggi-do 16677 (KR); JEONG, Hyunyong, Suwon-si, Gyeonggi-do 16677 (KR); CHOI, Hyungeun, Suwon-si, Gyeonggi-do 16677 (KR)
(74) Representative: Kuhnen & Wacker Patent- und Rechtsanwaltsbüro PartG mbB

(57) **Abstract**

A semiconductor device includes a capacitor on a first substrate, a channel on the capacitor, a gate electrode at least partially overlapping the channel in a horizontal direction, a bit line structure on the gate electrode and the channel, a first wiring structure on the bit line structure, a bonding pad structure on the first wiring structure, a second wiring structure on the bonding pad structure, a second substrate on the second wiring structure, a transistor beneath the second substrate, a third wiring structure on the second substrate, an isolation pattern extending through the second substrate, and a through via extending through the isolation pattern.

## Description

### CROSS-REFERENCE TO RELATED APPLICATION

This application claims priority to Korean Patent Application No. 10-2024-0097807 filed on July 24, 2024 in the Korean Intellectual Property Office, the disclosure of which is hereby incorporated by reference in its entirety.

### FIELD

Example embodiments of the present disclosure relate to a semiconductor device. More particularly, example embodiments of the present disclosure relate to a dynamic random access memory (DRAM) device.

### BACKGROUND

In order to improve an integration degree of a semiconductor device, a method of arranging memory cells and periphery circuit patterns for generating electrical signals to drive the memory cells is provided.

### SUMMARY

Example embodiments provide a semiconductor device having improved characteristics.

According to example embodiments of the present disclosure, a semiconductor device may include a capacitor spaced apart from a first substrate in a first direction, wherein the first direction is substantially perpendicular to an upper surface of the first substrate, a channel on the capacitor, a gate electrode at least partially overlapping the channel in a second direction, wherein the second direction is substantially parallel to the upper surface of the first substrate, a bit line structure on the gate electrode and the channel, a first wiring structure on the bit line structure, a bonding pad structure on the first wiring structure, a second wiring structure on the bonding pad structure, a second substrate on the second wiring structure, a transistor with impurity regions in the second substrate, a third wiring structure on the second substrate, an isolation pattern extending through opposite sides of the second substrate, and a through via extending inside the isolation pattern.

According to example embodiments of the present disclosure, a semiconductor device may include a capacitor spaced apart from a first substrate in a first direction, wherein the first direction is substantially perpendicular to an upper surface of the first substrate, a channel on the capacitor, a gate electrode at least partially overlapping the channel in a second direction, wherein the second direction is substantially parallel to the upper surface of the first substrate, a bit line structure on the gate electrode and the channel, a first wiring structure on the bit line structure, a bonding pad structure on the first wiring structure, a second wiring structure on the bonding pad structure, a second substrate on the second wiring structure, a transistor with impurity regions in the second substrate, an isolation pattern extending through the second substrate, and a through via extending through opposite sides of the isolation pattern. The through via may be connected to an input/output device and may transfer an input/output signal generated from the input/output device.

According to example embodiments of the present disclosure, a semiconductor device may include a capacitor spaced apart from a first substrate in a first direction, wherein the first direction is substantially perpendicular to an upper surface of the first substrate, a channel on the capacitor, a gate electrode at least partially overlapping the channel in a second direction, wherein the second direction is substantially parallel to the upper surface of the first substrate, a bit line structure on the gate electrode and the channel, a first wiring structure on the bit line structure, a bonding pad structure on the first wiring structure, a second wiring structure on the bonding pad structure, a second substrate on the second wiring structure, a transistor with impurity regions in the second substrate, a third wiring structure on the second substrate, an isolation pattern extending through opposite sides of the second substrate, and a plurality of through vias spaced apart from each other in the second direction. Each of the plurality of through vias may extend opposite sides of the isolation pattern.

In the semiconductor device in accordance with example embodiments, the memory cells, the peripheral circle pattern and the wiring structure may be efficiently arranged, and thus the semiconductor device may have an enhanced integration degree.

### BRIEF DESCRIPTION OF THE DRAWINGS

FIG. 1 is a cross-sectional view illustrating a semiconductor device in accordance with example embodiments.
FIGS. 2 to 16 are plan views and cross-sectional views illustrating a method of manufacturing a semiconductor device in accordance with example embodiments.
FIG. 17 is a cross-sectional view illustrating a semiconductor device in accordance with example embodiments.
FIG. 18 is a cross-sectional view illustrating a semiconductor device in accordance with example embodiments.
FIGS. 19 to 22 are cross-sectional views illustrating a method of manufacturing a semiconductor device.
FIG. 23 is a cross-sectional view illustrating a semiconductor device in accordance with example embodiments.
FIGS. 24 to 26 are cross-sectional views illustrating a method of manufacturing a semiconductor device.
FIG. 27 is a cross-sectional view illustrating a semiconductor device in accordance with example embodiments.
FIG. 28 is a cross-sectional view illustrating a method of manufacturing a semiconductor device.
FIG. 29 is a cross-sectional view illustrating a semiconductor device in accordance with example embodiments.

### DETAILED DESCRIPTION

The above and other aspects and features of a semiconductor device and a method of manufacturing the same in accordance with example embodiments will become readily understood from detail descriptions that follow, with reference to the accompanying drawings. It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

Hereinafter, in the specification (and not necessarily in the claims), two directions that are perpendicular or substantially perpendicular to each other among horizontal directions, which are parallel or substantially parallel to an upper surface of each of first, second and third substrates, may be referred to as first and second directions D1 and D2, respectively, and a vertical direction perpendicular or substantially perpendicular to the upper surface of each of the first to third substrates may be referred to as a third direction D3. In example embodiments, the first and second directions D1 and D2 may be perpendicular or substantially perpendicular to each other. Each of the first to third directions D1, D2 and D3 may include not only a direction shown in the drawings but also a direction that is opposite thereto.

The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present. Likewise, when components are "immediately" adjacent to one another, no intervening components may be present.

Components or layers described with reference to "overlap" in a particular direction may be at least partially obstructed by one another when viewed along a line extending in the particular direction or in a plane perpendicular to the particular direction. The term "surrounding" or "covering" or "filling" as may be used herein may not require completely surrounding or covering or filling the described elements or layers, but may, for example, refer to partially surrounding or covering or filling the described elements or layers, for example, with voids, spaces, or other discontinuities throughout. The term "exposed," may be used to describe relationships between elements and/or certain intermediate processes in fabricating a completed semiconductor device, but may not necessarily require exposure of the particular region, layer, structure or other element in the context of the completed device.

It will be understood that spatially relative terms such as "above," "upper," "upper portion," "upper surface," "below," "lower," "lower portion," "lower surface," "side surface," and the like may be denoted by reference numerals and refer to the drawings, except where otherwise indicated. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

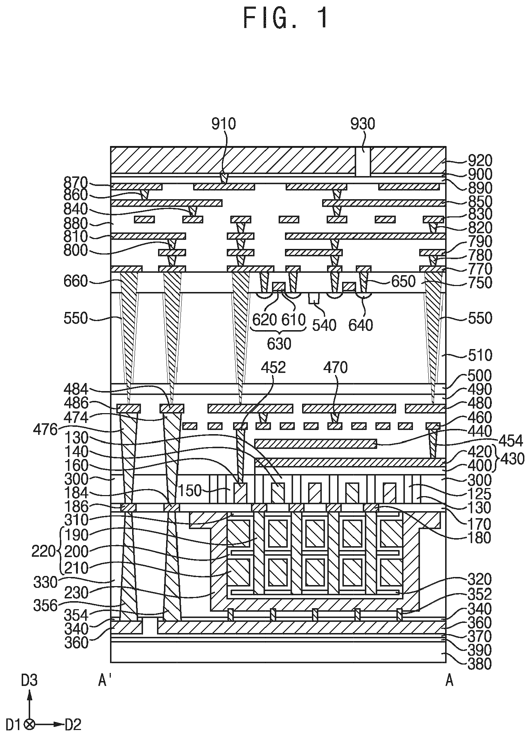

FIG. 1 is a cross-sectional view illustrating a semiconductor device in accordance with example embodiments.

Referring to FIG. 1, the semiconductor device may include memory cells on a second substrate 380 and a periphery circuit pattern for generating electrical signals to drive the memory cells on a third substrate 510. Hereinafter, regions in which the memory cells and the periphery circuit pattern are disposed may be referred to as a cell array region and a periphery circuit region, respectively.

Thus, the semiconductor device may have a periphery over cell (POC) structure in which the peripheral circuit region is disposed over the cell array region. However, the inventive concept is not limited thereto, and the semiconductor device may also have a cell over periphery (COP) structure in which the peripheral circuit region is disposed under the cell array region.

The semiconductor device may include a capacitor 220, a plate electrode 230, first to third conductive pads 180, 184 and 186, first and second gate electrodes 140 and 160, first and second gate insulation patterns 130 and 150, a channel 125, a bit line structure 430, a transistor and a wiring structure.

The semiconductor device may further include a first bonding layer 390, first to tenth insulating interlayers 300, 170, 330, 370, 490, 750, 500, 880, 890 and 930, and first and second isolation patterns 540 and 550.

The second substrate 380 may include a semiconductor material, e.g., silicon, or an insulating material, e.g., glass. The first bonding layer 390 may be bonded to an upper surface of the second substrate 380, and may include, e.g., silicon carbonitride, silicon oxide, etc. The fourth insulating interlayer 370 may be bonded to an upper surface of the first bonding layer 390, and may include an oxide, e.g., silicon oxide or a low-k dielectric material.

A first wiring 360 and a second etch stop layer 340 may be sequentially stacked in the third direction D3 on the fourth insulating interlayer 370. The second etch stop layer 340 may include an insulating nitride, e.g., silicon nitride.

Each of the second and third contact plugs 354 and 356 may extend through the third insulating interlayer 330 and the second etch stop layer 340 in the third direction D3, and may contact an upper surface of the first wiring 360. In example embodiments, a width in the horizontal direction of each of the second and third contact plugs 354 and 356 may gradually decrease from a bottom to a top thereof.

The capacitor 220 and the plate electrode 230 may be disposed on the second etch stop layer 340 in the third insulating interlayer 330, and a lower surface and a sidewall of the plate electrode 230 may be covered by the third insulating interlayer 330. The capacitor 220 may include a first capacitor electrode 190, a dielectric layer 200 and a second capacitor electrode 210.

The first capacitor electrode 190 may extend in the third direction D3, and a plurality of first capacitor electrodes 190 may be spaced apart from each other in each of the first and second directions D1 and D2. In example embodiments, the first capacitor electrode 190 may be arranged in a lattice pattern or a honeycomb pattern in a plan view.

A support layer 320 and a first etch stop layer 310 may be disposed on a sidewall of each of the first capacitor electrodes 190. The first etch stop layer 310 may be disposed on an uppermost portion of the sidewall of each of the first capacitor electrodes 190, and a plurality of support layers 320 may be spaced apart from each other in the third direction D3 on the sidewall of each of the first capacitor electrodes 190.

The dielectric layer 200 may be disposed on the sidewall of the first capacitor electrode 190, lower and upper surfaces and a sidewall of the support layer 320, and a lower surface and a sidewall of the first etch stop layer 310. The second capacitor electrode 210 may be disposed between ones of the support layers 320 neighboring in the third direction D3 and between an uppermost one of the support layers 320 and the first etch stop layer 310, and lower and upper surfaces and a sidewall of the second capacitor electrode 210 may be covered by the dielectric layer 200.

The plate electrode 230 may surround lower surfaces and sidewalls of the capacitor 220, the support layer 320 and the first etch stop layer 310.

Each of the first and second capacitor electrodes 190 and 210 may include, e.g., a metal, a metal nitride, a metal silicide, etc., and the dielectric layer 200 may include a metal oxide. The support layer 320 may include an insulating nitride, e.g., silicon nitride, and the first etch stop layer 310 may include an insulating nitride, e.g., silicon boronitride. The plate electrode 230 may include, e.g., doped silicon-germanium, or a metal, e.g., tungsten.

A first contact plug 352 may extend through a lower portion of the third insulating interlayer 330 and the second etch stop layer 340, and may contact the upper surface of the first wiring 360 and a lower surface of the plate electrode 230. The first contact plug 352 may extend partially through a lower portion of the plate electrode 230.

The second insulating interlayer 170 may be disposed on the third insulating interlayer 330, the capacitor 220, the plate electrode 230 and second and third contact plugs 354 and 356. The first to third conductive pads 180, 184 and 186 may extend through the second insulating interlayer 170, and may contact upper surfaces of the first capacitor electrode 190, the second contact plug 354 and the third contact plug 356, respectively. As the first capacitor electrodes 190 are arranged in, e.g., the lattice pattern or honeycomb pattern, the first conductive pads 180 may also be arranged in the lattice pattern or honeycomb pattern, corresponding to the first capacitor electrodes 190.

The second insulating interlayer 170 may include an oxide, e.g., silicon oxide or a low-k dielectric material. In example embodiments, each of the first to third conductive pads 180, 184 and 186 may include a second conductive pattern and a first conductive pattern that are sequentially stacked in the third direction D3. The second conductive pattern may include, e.g., a metal, a metal nitride, a metal silicide, etc., and the first conductive pattern may include, e.g., doped polysilicon etc.

In example embodiments, the first gate electrode 140 may extend in the first direction D1 on the second insulating interlayer 170, and a plurality of first gate electrodes 140 may be spaced apart from each other in the second direction D2. The second gate electrode 160 may extend in the first direction D1 on the second insulating interlayer 170, and a plurality of second gate electrodes 160 may be spaced apart from each other in the second direction D2. In example embodiments, the first and second gate electrodes 140 and 160 may be alternately and repeatedly disposed in the second direction D2.

In example embodiments, the first gate electrode 140 may have a straight bar shape extending in the first direction D1 in a plan view, while the second gate electrode 160 may include an extension portion straightly extending in the first direction D1 and protrusion portions, each of which may protrude in the second direction D2 from the extension portion, spaced apart from each other in the first direction D1.

Each of the first and second gate electrodes 140 and 160 may include a metal, e.g., tungsten, copper, aluminum, etc.

In example embodiments, the second gate electrode 160 may serve as a word line of the semiconductor device, and the first gate electrode 140 may serve as a back gate electrode of the semiconductor device. However, the inventive concept is not limited thereto. For example, the first gate electrode 140 may serve as the word line of the semiconductor device, and the second gate electrode 160 may serve as the back gate electrode of the semiconductor device.

In example embodiments, the first gate insulation pattern 130 may be disposed on the second insulating interlayer 170 and the first conductive pad 180, and may extend in the first direction D1 and cover an upper surface and a sidewall of the first gate electrode 140. The second gate insulation pattern 150 may be disposed on the second insulating interlayer 170 and the first conductive pad 180, and may extend in the first direction D1 and cover an upper surface and a sidewall of the second gate electrode 160. A cross-section of each of the first and second gate insulation patterns 130 and 150 in the second direction D2 may have, e.g., a reversed cup shape.

As the first and second gate electrodes 140 and 160 are alternately and repeatedly disposed in the second direction D2, the first and second gate insulation patterns 130 and 150 may also be alternately and repeatedly disposed in the second direction D2.

In example embodiments, each of opposite sidewalls in the second direction D2 of the first gate insulation pattern 130 may have a shape of a straight bar extending in the first direction D1 in a plan view, while each of opposite sidewalls in the second direction D2 of the second gate insulation pattern 150 may have a zigzag pattern in a plan view. Each of the first and second gate insulation patterns 130 and 150 may include an oxide, e.g., silicon oxide.

The channel 125 may be disposed on an outer sidewall of the first gate insulation pattern 130 in the second direction D2 on the first conductive pad 180, and a plurality of channels 125 may be spaced apart from each other in the first direction. A first sidewall in the second direction D2 of each of the channels 125 may contact the outer sidewall in the second direction D2 of the first gate insulation pattern 130, and a second sidewall in the second direction D2 and opposite sidewalls in the first direction D1 of each of the channels 125 may contact an outer sidewall in the second direction D2 of the second gate insulation pattern 150.

In example embodiments, the channel 125 may include a semiconductor material, e.g., silicon, germanium, silicon-germanium, etc. Alternatively, the channel 125 may include an oxide semiconductor material, e.g., indium gallium zinc oxide (IGZO).

The first insulating interlayer 300 may be disposed on the second insulating interlayer 170 and the second and third conductive pads 184 and 186, and may contact a sidewall of one of the first gate insulation patterns 130 at each of opposite sides in the second direction D2. The first insulating interlayer 300 may include an oxide, e.g., silicon oxide or a low-k dielectric material.

The bit line structure 430 may extend in the second direction D2 on the channel 125, the first and second gate insulation patterns 130 and 150 and the first insulating interlayer 300, and a plurality of bit line structures 430 may be spaced apart from each other in the first direction D1. Each of the bit line structures 430 may commonly contact upper surfaces of ones of the channels 125 disposed in the second direction D2.

In an example embodiment, each of the bit line structures 430 may include third and fourth conductive patterns 400 and 420 stacked in the third direction D3, and may include, e.g., doped polysilicon and a metal, respectively.

Second to sixth wirings 440, 460, 480, 484 and 486, fourth to seventh contact plugs 452, 454, 474 and 476, and a first via 470 may be disposed in a fifth insulating interlayer 490 that may be disposed on the channel 125, the first and second gate insulation patterns 130 and 150, the first insulating interlayer 300, and the second and third conductive pads 184 and 186.

The second to fourth wirings 440, 460 and 480 may be sequentially stacked in the third direction D3 in this order, and the fifth and sixth wirings 484 and 486 may be spaced apart from the fourth wiring 480 in the horizontal direction at a level substantially the same as a level of the fourth wiring 480.

The fourth contact plug 452 may extend through a portion of the fifth insulating interlayer 490 and the second gate insulation pattern 150, and may contact a lower surface of the third wiring 460 and the upper surface of the second gate electrode 160. The fifth contact plug 454 may extend through a portion of the fifth insulating interlayer 490, and may contact the lower surface of the third wiring 460 and an upper surface of the bit line structure 430. The sixth contact plug 474 may extend through the fifth insulating interlayer 490 and the first insulating interlayer 300, and may contact a lower surface of the fifth wiring 484 and an upper surface of the second conductive pad 184. The seventh contact plug 476 may extend through the fifth insulating interlayer 490 and the first insulating interlayer 300, and may contact a lower surface of the sixth wiring 486 and an upper surface of the third conductive pad 186.

In example embodiments, each of the fourth to seventh contact plugs 452, 454, 474 and 476 may have a width that gradually increases from a bottom to a top thereof.

The first via 470 may extend through a portion of the fifth insulating interlayer 490, and may contact an upper surface of the third wiring 460 and a lower surface of the fourth wiring 480.

The seventh insulating interlayer 500 may include an oxide, e.g., silicon oxide or a silicon carbonitrde.

The third substrate 510 may be disposed on the seventh insulating interlayer 500. The third substrate 510 may include a semiconductor material, e.g., silicon, germanium, silicon-germanium, etc., and a well region doped with, e.g., p-type impurities, may be disposed in the third substrate 510.

The first isolation pattern 540 may be disposed at an upper portion of the third substrate 510, and the second isolation pattern 550 may extend through the third substrate 510. FIG. 1 shows four second isolation patterns 550, however, the inventive concept is not limited thereto, and a plurality of second isolation patterns 550 may be disposed.

Each of the first and second isolation patterns 540 and 550 may include an oxide, e.g., silicon oxide.

A gate structure 630 may be disposed on the third substrate 510, and impurity regions 640 may be disposed at upper portions, respectively, of the third substrate 510 adjacent to the gate structure 630.

The gate structure 630 may include a third gate insulation pattern 620 and a third gate electrode 610 stacked in the third direction D3, and the gate structure 630 and the impurity regions 640 may collectively form a transistor.

The third gate electrode 610 may include a conductive material, e.g., a metal, a metal nitride, a metal silicide, etc., and the third gate insulation pattern 620 may include an oxide, e.g., silicon oxide.

The sixth and eighth insulating interlayers 750 and 880 may be stacked in the third direction D3 on the third substrate 510. Each of the sixth and eighth insulating interlayers 750 and 880 may include an oxide, e.g., silicon oxide or a low-k dielectric material.

An eighth contact plug 650 may extend through the sixth insulating interlayer 750, and may contact an upper surface of each of the impurity regions 640. A through via 660 may extend through the sixth insulating interlayer 750, the second isolation pattern 550, the seventh insulating interlayer 500 and the fifth insulating interlayer 490, and may contact the upper surface of the fourth wiring 480. The through vias 660 also extend inside the second isolation pattern 550. In example embodiments, a width of each of the eighth contact plug 650 and the through via 660 may gradually decrease from a top to a bottom thereof.

Seventh to twelfth wirings 770, 790, 810, 830, 850 and 870 may be sequentially stacked in the third direction D3 in this order.

A second via 780 may extend through a portion of the eighth insulating interlayer 880, and may contact an upper surface of the seventh wiring 770 and a lower surface of the eighth wiring 790. A third via 800 may extend through a portion of the eighth insulating interlayer 880, and may contact an upper surface of the eighth wiring 790 and a lower surface of the ninth wiring 810. A fourth via 820 may extend through a portion of the eighth insulating interlayer 880, and may contact an upper surface of the ninth wiring 810 and a lower surface of the tenth wiring 830. A fifth via 840 may extend through a portion of the eighth insulating interlayer 880, and may contact an upper surface of the tenth wiring 830 and a lower surface of the eleventh wiring 850. A sixth via 860 may extend through a portion of the eighth insulating interlayer 880, and may contact an upper surface of the eleventh wiring 850 and a lower surface of the twelfth wiring 870.

FIG. 1 shows that the seventh to twelfth wirings 770, 790, 810, 830, 850 and 870 are stacked in six levels, respectively, in the third direction D3 in the eighth insulating interlayer 880, however, the inventive concept is not limited thereto.

The ninth insulating interlayer 890 and a third etch stop layer 900 may be disposed on the eighth insulating interlayer 880 and the twelfth wiring 870 sequentially stacked in the third direction D3, and a thirteenth wiring 920 and the tenth insulating interlayer 930 may be disposed on the third etch stop layer 900. A seventh via 910 may extend through the ninth insulating interlayer 890 and the third etch stop layer 900, and may contact an upper surface of the twelfth wiring 870. In example embodiments, the thirteenth wiring 920 may apply an input/output signal.

Each of the first to thirteenth wirings 360, 440, 460, 480, 484, 486, 770, 790, 810, 830, 850, 870 and 920, the first to eighth contact plugs 352, 354, 356, 452, 454, 474, 476 and 650, the through via 660, and the first and seventh vias 470, 780, 800, 820, 840, 860 and 910 included in the wiring structure may include, e.g., a metal, a metal nitride, a metal silicide, etc.

The wiring structure may include a signal line for transferring an electric signal generated from the periphery circuit pattern to the memory cells, and a power line for providing power to the periphery circuit pattern and the memory cells.

In an example embodiment, the signal line may be disposed under and over the third substrate 510, and the power line may be disposed over the third substrate 510. The power line may include, e.g., the ninth to twelfth wirings 810, 830, 850 and 870, and the third to sixth vias 800, 820, 840 and 860, however, the inventive concept is not limited thereto.

In the semiconductor device, currents may flow in the channel 125 in the third direction D3, which is the vertical direction, between the bit line structure 430 and the first conductive pad 180, and thus the semiconductor device may be a VCT DRAM device that may include a vertical channel transistor having a vertical channel.

In the semiconductor device of FIG. 1, the plate electrode 230 in the cell array region may be arranged to face downwardly in the third direction D3, and the transistor in the peripheral circuit region may be arranged to face upwardly in the third direction D3 on the third substrate 510.

However, the inventive concept is not limited thereto, and for example, the plate electrode 230 may be arranged to face upwardly in the third direction D3, or the transistor may be arranged to face downwardly in the third direction D3 beneath the third substrate 510.

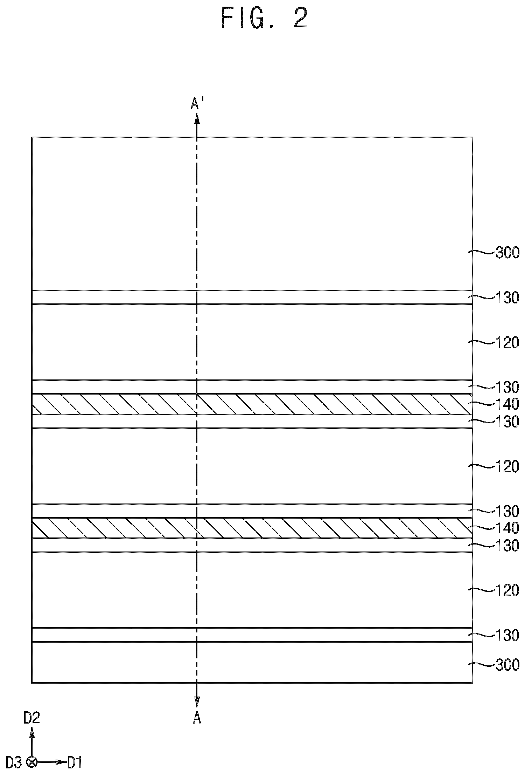

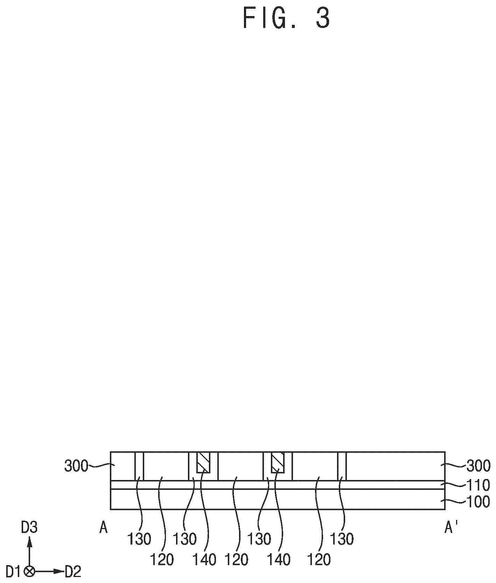

FIGS. 2 to 16 are plan views and cross-sectional views illustrating a method of manufacturing a semiconductor device in accordance with example embodiments. Specifically, FIGS. 2, 4 and 6 are the plan views, and FIGS. 3, 5 and 7-16 are cross-sectional views taken along lines A-A' of corresponding plan views, respectively.

Referring to FIGS. 2 and 3, a first substrate structure including a first bulk substrate 100, a buried oxide layer 110 and a second bulk substrate may be provided, and the second bulk substrate may be patterned to form a preliminary channel 120.

In example embodiments, the preliminary channel 120 may extend in the first direction D1, and a plurality of preliminary channels 120 may be spaced apart from each other in the second direction D2. A first opening may be formed between ones of the preliminary channels 120 neighboring in the second direction D2 to expose an upper surface of the buried oxide layer 110.

A first gate insulation layer may be formed on the preliminary channel 120 and the buried oxide layer 110, an anisotropic etching process may be performed on the first gate insulation layer to remove a portion of the first gate insulation layer on an upper surface of the preliminary channel 120. Thus, a first gate insulation pattern 130 may be formed on a sidewall of the first opening and the upper surface of the buried oxide layer 110. In example embodiments, the first gate insulation pattern 130 may contact opposite sidewalls in the second direction D2 of respective ones of the preliminary channels 120 neighboring in the second direction D2 and an upper surface of a portion of the buried oxide layer 110 between the neighboring ones of the preliminary channels 120, and may extend in the first direction D1.

A first gate electrode layer may be formed on the preliminary channel 120 and the first gate insulation pattern 130, and a planarization process may be performed on the first gate electrode layer until the upper surface of the preliminary channel 120 and an upper surface of the first gate insulation pattern 130 are exposed to form a first gate electrode 140. The planarization process may include, e.g., a chemical mechanical polishing (CMP) process and/or an etch back process.

In example embodiments, the first gate electrode 140 may extend in the first direction D1, and a plurality of first gate electrodes 140 may be spaced apart from each other in the second direction D2.

The preliminary channel 120, the first gate insulation pattern 130 and the first gate electrode 140 may be partially removed to form a second opening exposing the upper surface of the buried oxide layer 110, and a first insulating interlayer 300 may be formed in the second opening.

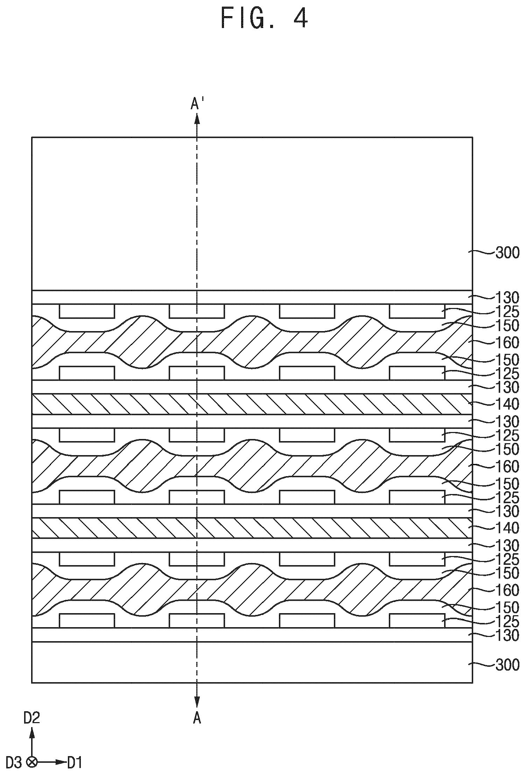

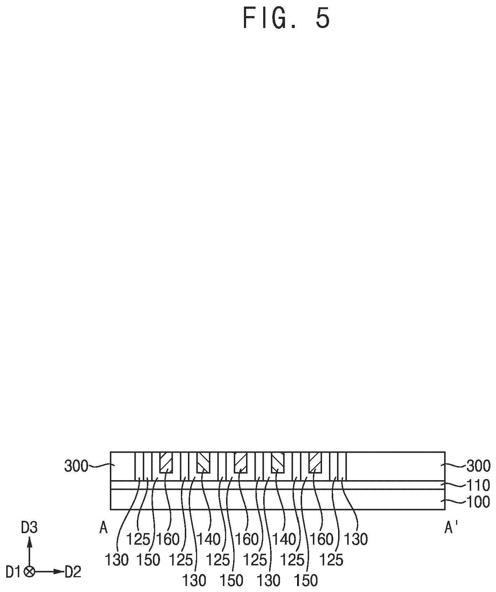

Referring to FIGS. 4 and 5, the preliminary channel 120 may be patterned to form a channel 125.

In example embodiments, a plurality of channels 125 may be spaced apart from each other in the first direction D1 on a sidewall in the second direction D2 of the first gate insulation pattern 130 extending in the first direction D1. A third opening may be formed between ones of the channels 125 that are disposed between ones of the first gate insulation patterns 130 neighboring in the second direction D2, and may expose the upper surface of the buried oxide layer 110.

A second gate insulation layer may be formed on the channel 125, the first gate insulation pattern 130, the first gate electrode 140 and the buried oxide layer 110, and a portion of the second gate insulation layer on an upper surface of the channel 125, the upper surface of the first gate insulation pattern 130 and an upper surface of the first gate electrode 140 may be removed by, e.g., an anisotropic etching process to form a second gate insulation pattern 150.

In example embodiments, the second gate insulation pattern 150 may contact opposite sidewalls in the second direction D2 of ones of the first gate insulation patterns 130 neighboring in the second direction D2, opposite sidewalls in the second direction D2 of ones of the channels 125 neighboring in the second direction D2, the upper surface of a portion of the buried oxide layer 110 between the neighboring ones of the first gate insulation patterns 130 and the upper surface of a portion of the buried oxide layer 110 between the neighboring ones of the channels 125, and may extend in the first direction D1.

A second gate electrode layer may be formed on the channel 125, the first and second gate insulation patterns 130 and 150, the first gate electrode 140 and the first insulating interlayer 300, and a planarization process may be performed on the second gate electrode layer until the upper surfaces of the channel 125, the first gate insulation pattern 130 and the first gate electrode 140, and upper surfaces of the second gate insulation pattern 150 and the first insulating interlayer 300 are exposed to form a second gate electrode 160. The planarization process may include a CMP process and/or an etch back process.

In example embodiments, the second gate electrode 160 may extend in the first direction D1, and a plurality of second gate electrodes 160 may be spaced apart from each other in the second direction D2. In example embodiments, the second gate electrode 160 may include an extension portion straightly extending in the first direction D1 and protrusion portions that may protrude from the extension portion in the second direction D2 and be spaced apart from each other in the first direction D1, in a plan view.

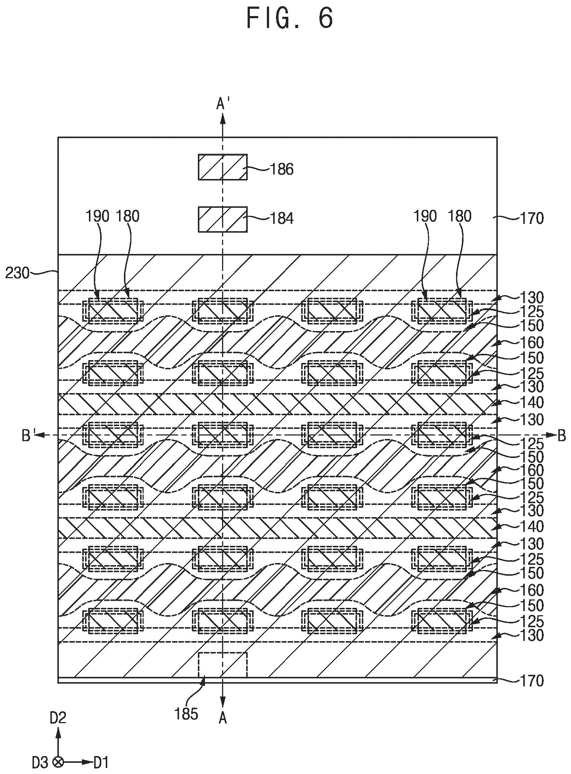

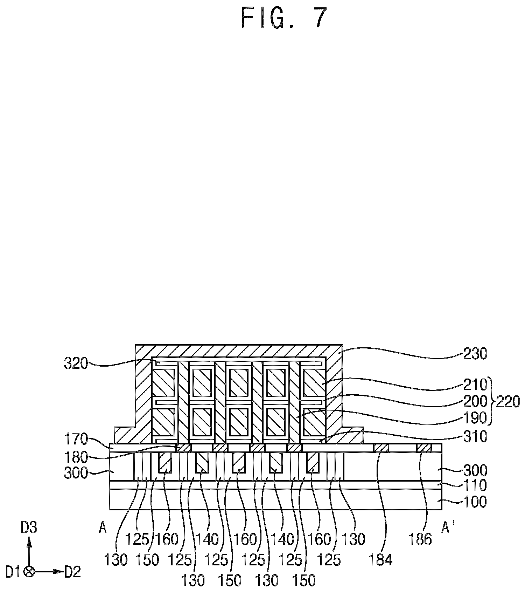

Referring to FIGS. 6 and 7, a second insulating interlayer 170 may be formed on the first and second gate electrodes 140 and 160, the channel 125, the first and second gate insulation patterns 130 and 150 and the first insulating interlayer 300, and first to third conductive pads 180, 184 and 186 may be formed through the second insulating interlayer 170.

In example embodiments, a plurality of first conductive pads 180 may be spaced apart from each other in each of the first and second directions D1 and D2 to contact upper surfaces of corresponding ones of the channels 125, respectively. The second and third conductive pads 184 and 186 may be formed through a portion of the second insulating interlayer 170 on the first insulating interlayer 300.

In an example embodiment, each of the first to third conductive pads 180, 184 and 186 may include first and second conductive patterns stacked in the third direction D3. The first conductive pattern may include, e.g., doped polysilicon, and the second conductive pattern may include, e.g., a metal, a metal nitride, a metal silicide, etc.

A capacitor 220 and a plate electrode 230 may be formed on the second insulating interlayer 170 and the first conductive pad 180. The capacitor 220 and the plate electrode 230 may be formed by, e.g., following processes.

A first etch stop layer 310 may be formed on the second insulating interlayer 170 and the first to third conductive pads 180, 184 and 186, and a mold layer and a support layer 320 may be alternately and repeatedly formed on the first etch stop layer 310. The first etch stop layer 310 may include an insulating nitride, e.g., silicon boronitride, the mold layer may include an oxide, e.g., silicon oxide, and the support layer 320 may include an insulating nitride, e.g., silicon nitride.

A fourth opening may be formed through the support layer 320, the mold layer and the first etch stop layer 310 to expose an upper surface of the first conductive pad 180, a first capacitor electrode layer may be formed on the upper surface of the first conductive pad 180, a sidewall of the fourth opening and an upper surface of an uppermost one of the support layers 320, and a planarization process may be performed on the first capacitor electrode layer until the upper surface of the uppermost one of the support layers 320 is exposed to form a first capacitor electrode 190 in the fourth opening.

The planarization process may include, e.g., a CMP process and/or an etch back process.

The support layer 320 and the mold layer may be partially removed to form a fifth opening exposing an upper surface of the first etch stop layer 310, and the mold layer may be removed through the fifth opening.

In example embodiments, the mold layer may be removed by a wet etching process, and as the wet etching process is performed, a sixth opening may be formed to expose a sidewall of the first capacitor electrode 190 and the upper surface of the first etch stop layer 310. However, the support layers 320 may remain on the sidewall of each of the first capacitor electrodes 190, and thus a surface of each of the support layers 320 may be exposed by the sixth opening.

A dielectric layer 200 may be formed on the sidewall of each of the first capacitor electrodes 190, the upper surface of the first etch stop layer 310 and the surface of each of the support layers 320 exposed by the sixth opening, and a second capacitor electrode layer may be formed on the dielectric layer 200 to fill the sixth opening. The dielectric layer 200 and the second capacitor electrode layer may also be formed on an upper surface of the first capacitor electrode 190 and the upper surface of the uppermost one of the support layers 320.

For example, a wet etching process may be performed on the second capacitor electrode layer to form a second capacitor electrode 210 in the sixth opening. The first capacitor electrode 190, the dielectric layer 200 and the second capacitor electrode 210 may collectively form a capacitor 220.

A plate electrode 230 may be formed on an upper surface and a sidewall of the capacitor 220 and an upper surface of the second insulating interlayer 170.

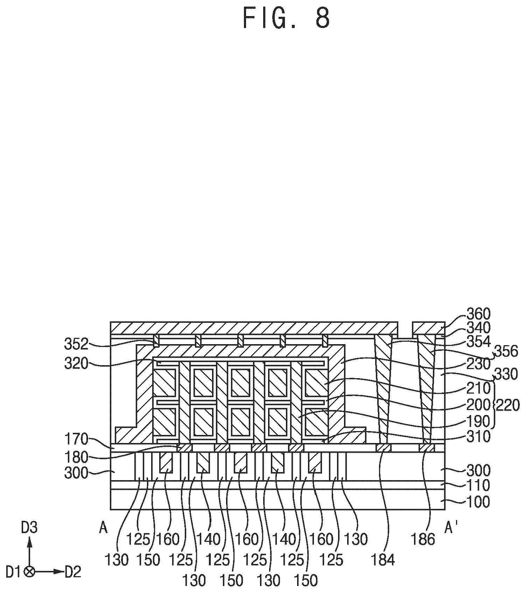

Referring to FIG. 8, a third insulating interlayer 330 may be formed on the second insulating interlayer 170 and the second and third conductive pads 184 and 186 to cover the plate electrode 230, and a second etch stop layer 340 may be formed on the third insulating interlayer 330. A first contact plug 352 may be formed through the second etch stop layer 340 to contact an upper surface of the plate electrode 230, and second and third contact plugs 354 and 356 may be formed through the second etch stop layer 340 and the third insulating interlayer 330 to contact upper surfaces of the second and third conductive pads 184 and 186, respectively.

In example embodiments, each of the second and third contact plugs 354 and 356 may be formed to have a width that gradually decreases from a top to a bottom thereof, depending on the characteristics of an etching process for forming the second and third contact plugs 354 and 356.

A first wiring layer may be formed on the second etch stop layer 340 and the first to third contact plugs 352, 354 and 356, and may be partially etched to form a first wiring 360. The second etch stop layer 340 may also be partially etched so that a portion of an upper surface of the third insulating interlayer 330 may be exposed.

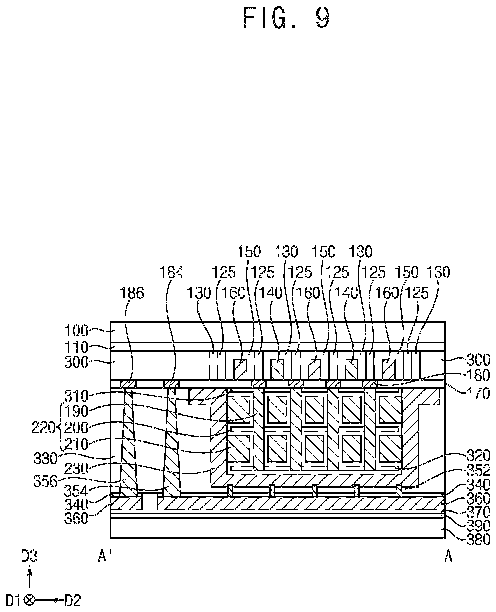

Referring to FIG. 9, a fourth insulating interlayer 370 may be formed on the third insulating interlayer 330 to cover the first wiring 360, and a second substrate 380 may be bonded to an upper surface of the fourth insulating interlayer 370 via a first bonding layer 390 therebetween.

The second substrate 380 may include a semiconductor material, e.g., silicon, or an insulating material, e.g., glass, and the first bonding layer 390 may include, e.g., silicon carbonitride, silicon oxide, etc.

The second substrate 380 may be flipped so that top and bottom of a structure on the second substrate 380 may be reversed. Thus, following explanation is based on the reversed direction.

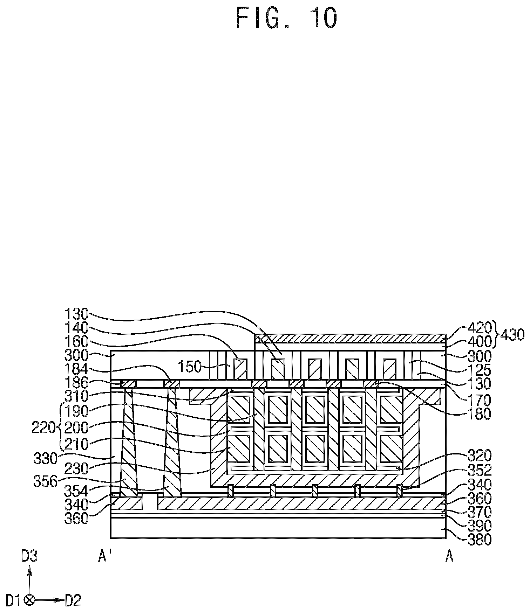

Referring to FIG. 10, the first bulk substrate 100 and the buried oxide layer 110 included in the first substrate structure may be removed by, e.g., a grinding process, and thus upper surfaces of the channel 125, the first and second gate insulation patterns 130 and 150 and the first insulating interlayer 300 may be exposed.

A bit line structure 430 may be formed on the upper surfaces of the channel 125, the first and second gate insulation patterns 130 and 150 and the first insulating interlayer 300. In example embodiments, the bit line structure 430 may extend in the second direction D2, and a plurality of bit line structures 430 may be spaced apart from each other in the first direction D1. Each of the bit line structures 430 may contact the upper surfaces of ones of the channels 125 that are disposed in the second direction D2.

In an example embodiment, each of the bit line structures 430 may include third and fourth conductive patterns 400 and 420 stacked in the third direction D3, which may include, e.g., doped polysilicon and a metal, respectively.

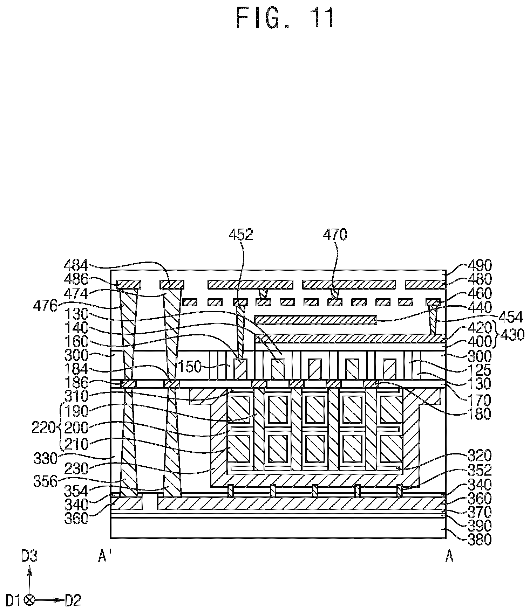

Referring to FIG. 11, second to sixth wirings 440, 460, 480, 484 and 486, fourth to seventh contact plugs 452, 454, 474 and 476 and a first via 470 may be formed on the bit line structure 430, and a fifth insulating interlayer 490 may be formed on the channel 125, the first and second gate insulation patterns 130 and 150 and the first insulating interlayer 300 to cover the second to sixth wirings 440, 460, 480, 484 and 486, the fourth to seventh contact plugs 452, 454, 474 and 476 and the first via 470.

In example embodiments, each of the fourth to seventh contact plugs 452, 454, 474 and 476 and the first via 470 may be formed to have a width that gradually decreases from a top to a bottom thereof, depending on the characteristics of etching processes for forming the fourth to seventh contact plugs 452, 454, 474 and 476 and the first via 470.

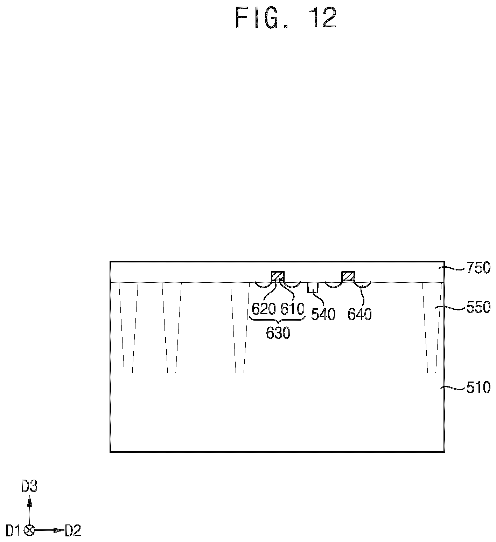

Referring to FIG. 12, first and second isolation patterns 540 and 550 may be formed at an upper portion of the third substrate 510.

The first and second isolation patterns 540 and 550 may be formed by partially removing upper portions of the third substrate 510 to form first and second trenches, respectively, forming an isolation layer on the third substrate 510 to fill the first and second trenches, and performing a planarization process, e.g., a CMP process and/or an etch back process on the isolation layer.

In example embodiments, a lower surface of the first isolation pattern 540 may be higher than a lower surface of the second isolation pattern 550. Each of the first and second isolation patterns 540 and 550 may include an oxide, e.g., silicon oxide.

A gate structure 630 may be formed on the third substrate 510, and impurity regions 640 may be formed at upper portions, respectively, adjacent to the gate structure 630.

The gate structure 630 may include a third gate insulation pattern 620 and a third gate electrode 610 stacked in the third direction D3, and the gate structure 630 and the impurity regions 640 may collectively form a transistor.

A sixth insulating interlayer 750 may be formed on the third substrate 510 to cover the transistor.

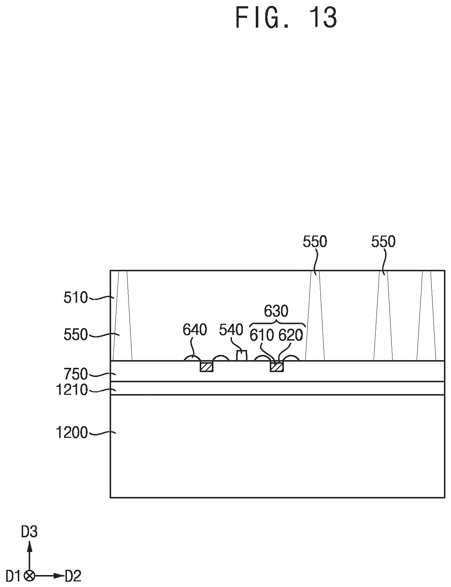

Referring to FIG. 13, a fourth substrate 1200 may be bonded to an upper surface of the sixth insulating interlayer 750 via a second bonding layer 1210 therebetween.

The fourth substrate 1200 may include a semiconductor material, e.g., silicon, or an insulating material, e.g., glass. The second bonding layer 1210 may include, e.g., silicon carbonitride, silicon oxide, etc.

The fourth substrate 1200 may be flipped so that top and bottom of a structure on the fourth substrate 1200 may be reversed. Thus, following explanation is based on the reversed direction.

An upper portion of the third substrate 510 may be removed by, e.g., a grinding process. In example embodiments, the grinding process may be performed until an upper surface of the second isolation pattern 550 is exposed. That is, the second isolation pattern 550 may serve as an end point for the grinding process.

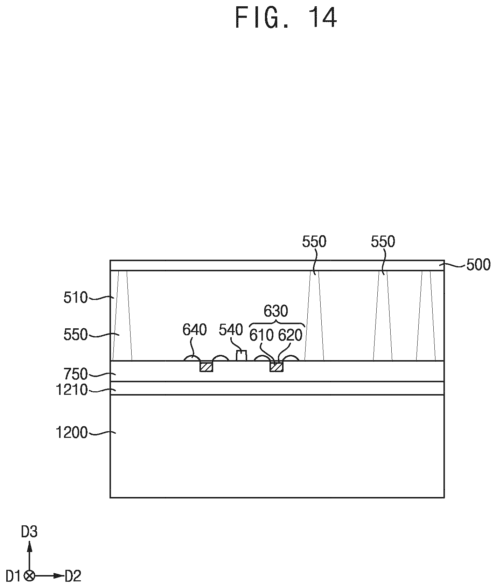

Referring to FIG. 14, a seventh insulating interlayer 500 may be formed on the third substrate 510 and the upper surface of the second isolation pattern 550.

In example embodiments, the seventh insulating interlayer 500 may include an oxide, e.g., silicon oxide or silicon carbonitride. In an example embodiment, the seventh insulating interlayer 500 may include substantially the same material as the second isolation pattern 550, e.g., silicon oxide, so as to be merged with the second isolation pattern 550.

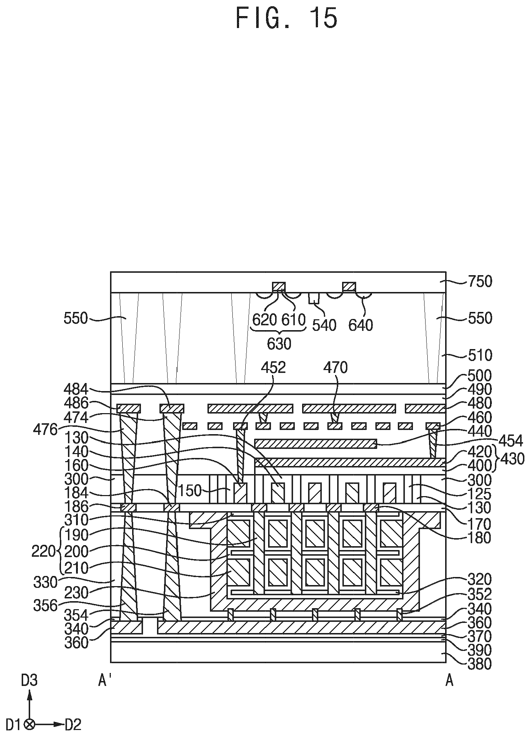

Referring to FIG. 15, the fourth substrate 1200 may be flipped, and the seventh insulating interlayer 500 may contact the fifth insulating interlayer 490 to be bonded thereto.

The fourth substrate 1200 and the second bonding layer 1210 may be removed by, e.g., a grinding process.

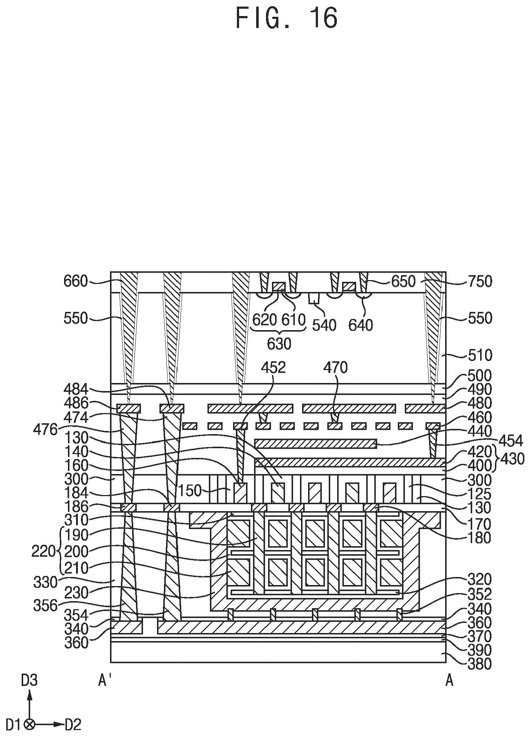

Referring to FIG. 16, a seventh opening extending through the sixth insulating interlayer 750 to expose an upper surface of the impurity region 640, and an eighth opening extending through the sixth insulating interlayer 750, the second isolation pattern 550, the seventh insulating interlayer 500 and an upper portion of the fifth insulating interlayer 490 to expose an upper surface of each of the fourth to sixth wirings 480, 484 and 486 may be formed by an etching process.

An eighth contact plug 650 and a through via 660 may be formed in the seventh and eighth openings, respectively.

Due to the characteristics of the etching process for forming the seventh and eighth openings, each of the eighth contact plug 650 and the through via 660 may be formed to have a width that may gradually decrease from a top to a bottom thereof.

Referring to FIG. 1 again, seventh to twelfth wirings 770, 790, 810, 830, 850 and 870 and second to sixth vias 780, 800, 820, 840 and 860 may be formed on the sixth insulating interlayer 750, the eighth contact plug 650 and the through via 660, and an eighth insulating interlayer 880 may be formed to cover the seventh to twelfth wirings 770, 790, 810, 830, 850 and 870 and the second to sixth vias 780, 800, 820, 840 and 860.

A ninth insulating interlayer 890 and a third etch stop layer 900 may be sequentially formed on the eighth insulating interlayer 880 and the twelfth wiring 870, a seventh via 910 may be formed through the ninth insulating interlayer 890 and the third etch stop layer 900 to contact an upper surface of the twelfth wiring 870, a thirteenth wiring 920 may be formed on the third etch stop layer 900 to contact an upper surface of the seventh via 910, and a tenth insulating interlayer 930 may be formed to cover a sidewall of the thirteenth wiring 920, so that the fabrication of the semiconductor device may be completed.

As illustrated above, when the first isolation pattern 540 is formed in the third substrate 510, the second isolation pattern 550 having a deeper bottom may be formed, and after flipping the third substrate 510, when the upper portion of the third substrate 510 is removed by a grinding process, the second isolation pattern 550 may serve as an end point of the grinding process. Thus, the third substrate 510 on which the peripheral circuit pattern such as the transistor may be bonded with a proper thickness to the second substrate 380 on which the memory cells are formed.

The second isolation pattern 550 may extend through the third substrate 510 after the grinding process. Thus, the through via 660, which may contact the wirings electrically connected to the peripheral circuit pattern, e.g., the seventh wiring 770, and the wirings on and electrically connected to the memory cells, e.g., the fourth to sixth wirings 480, 484 and 486, may be formed through the second isolation pattern 550 so as to be electrically insulated from the third substrate 510.

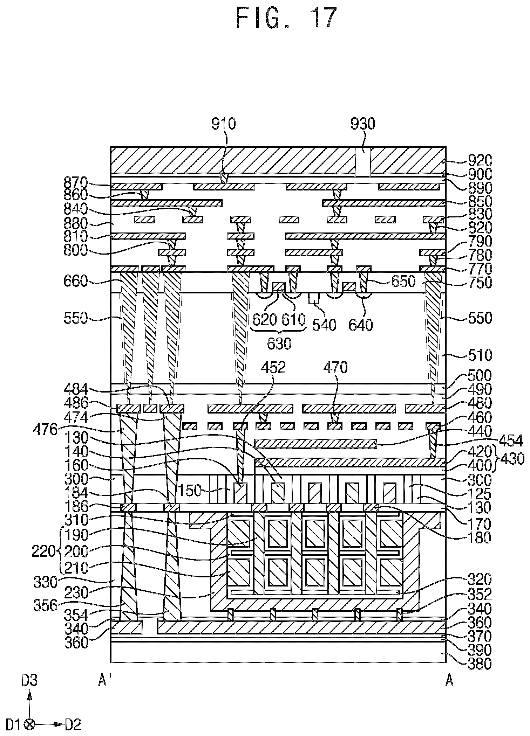

FIG. 17 is a cross-sectional view illustrating a semiconductor device in accordance with example embodiments, which may correspond to FIG. 1. This semiconductor device may be substantially the same as or similar to that of FIG. 1, except for the through via, and thus repeated explanations are omitted herein.

Referring to FIG. 17, a plurality of through vias 660 may extend in and through the second isolation pattern 550.

That is, the plurality of through vias 660 may be spaced apart from each other in each of the first and second directions D1 and D2 in the second isolation pattern 550.

The through vias 660 may extend through the sixth insulating interlayer 750, the second isolation pattern 550, the seventh insulating interlayer 500 and the upper portion of the fifth insulating interlayer 490, so that an additional insulating spacer for electrically insulating the through vias 660 from each other may not be formed. The through vias 660 also extend inside the second isolation pattern 550.

If the second isolation pattern 550 is not formed in the third substrate 510 and the through vias 660 are formed through the third substrate 510, openings may be formed through the third substrate 510, an insulating spacer may be formed on a sidewall of each of the openings, and the through vias 660 may be formed in the openings, respectively, in order to prevent an electrical short between the through vias 660. Thus, each of the openings may have an increased width for forming the insulating spacer, so that the through vias 660 may not be formed with a high density.

However, in example embodiments, the through vias 660 may be formed through the second isolation pattern 550 in the third substrate 510, so that no insulating spacer may be formed in each of the openings. Accordingly, each of the openings may have a relatively small width, so that the through vias 660 may be formed at a desired region with a high density. As a result, the wirings included in the wiring structure may have an increased degree of freedom, and the semiconductor device may have an enhanced integration degree.

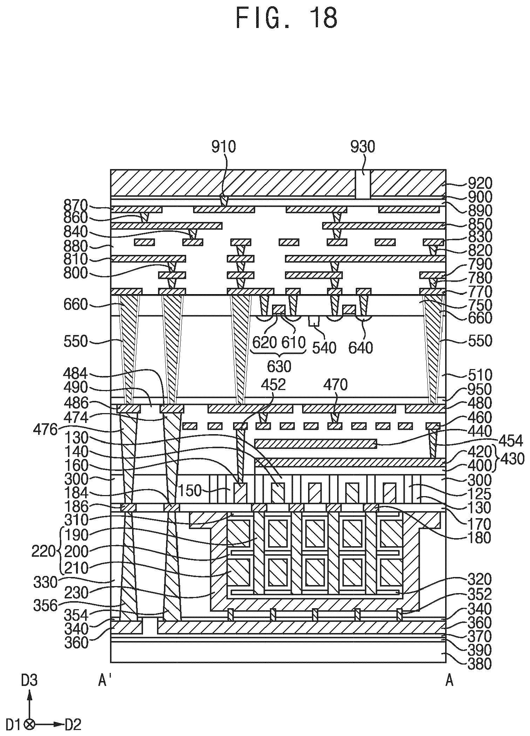

FIG. 18 is a cross-sectional view illustrating a semiconductor device in accordance with example embodiments, which may correspond to FIG. 1. This semiconductor device may be substantially the same as or similar to that of FIG. 1, except for the through via and the second isolation pattern, and thus repeated explanations are omitted herein.

Referring to FIG. 18, the second isolation pattern 550 may extend through not only the third substrate 510 but also the sixth insulating interlayer 750 and a third bonding layer 950, and the through via 660 may extend inside and through the second isolation pattern 550 and contact a lower surface of the seventh wiring 770 and an upper surface of each of the fourth to sixth wirings 480, 484 and 486.

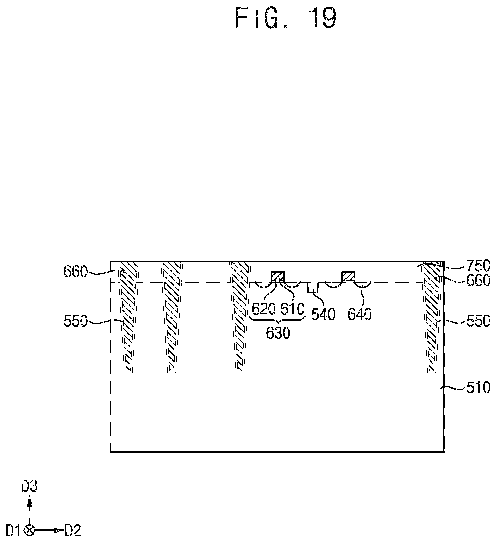

FIGS. 19 to 22 are cross-sectional views illustrating a method of manufacturing a semiconductor device, particularly, the semiconductor device of FIG. 18. This method may include processes substantially the same as or similar to those illustrated with respect to FIGS. 2 to 16 and FIG. 1, and thus repeated explanations are omitted herein.

Referring to FIG. 19, processes substantially the same as or similar to those illustrated with respect to FIGS. 2 to 12 may be performed.

However, the fifth insulating interlayer 490 may cover a sidewall of each of the fourth to sixth wirings 480, 484 and 486, but expose an upper surface of each of the fourth to sixth wirings 480, 484 and 486.

The second isolation pattern 550 may extend through the sixth insulating interlayer 750 as well as the third substrate 510. The through via 660 may be formed in the second isolation pattern 550.

In an example embodiment, the second isolation pattern 550 and the through via 660 may be formed by forming a third trench through the sixth insulating interlayer 750 and an upper portion of the third substrate 510, forming a second isolation layer on an inner wall of the third trench and an upper surface of the sixth insulating interlayer 750, forming a through via layer on the second isolation layer to fill the third trench, and performing a planarization process, e.g., a CMP process and/or an etch back process on the through via layer until the upper surface of the sixth insulating interlayer 750 is exposed.

Thus, a sidewall and a lower surface of the through via 660 may be covered by the second isolation pattern 550.

Alternatively, the through via 660 may be formed by forming the second isolation pattern 550 to fill the third trench, partially removing the second isolation pattern 550 to form a fourth trench, forming a through via layer to fill the fourth trench, and performing a planarization process on the through via layer.

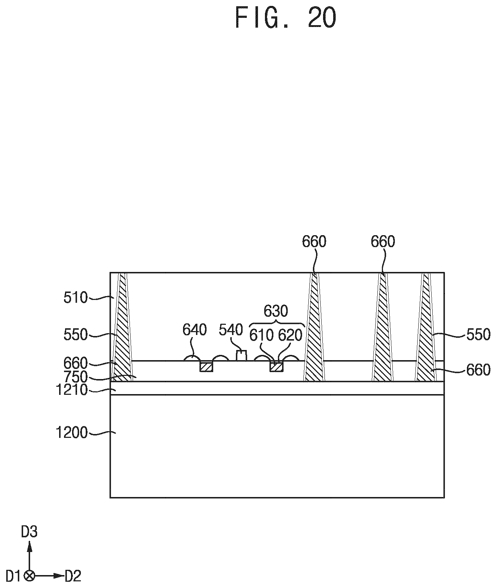

Referring to FIG. 20, processes substantially the same as or similar to those illustrated with respect to FIG. 13 may be performed.

Thus, the fourth substrate 1200 may be bonded to the upper surfaces of the sixth insulating interlayer 750, the second isolation pattern 550 and the through via 660 with the second bonding layer 1210 therebetween. The fourth substrate 1200 may be flipped, and the upper portion of the third substrate 510 may be removed by, e.g., a grinding process, so that the upper surface of the through via 660 may be exposed and a portion of the second isolation pattern 550 on the upper surface of the through via 660 may be removed.

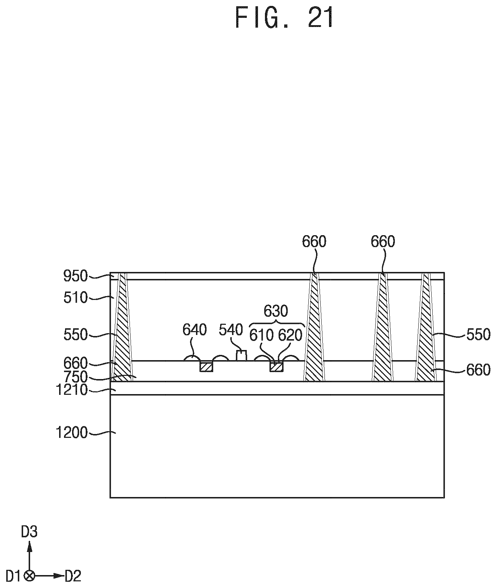

Referring to FIG. 21, an upper portion of the third substrate 510 may be further removed so that an upper portion of the through via 660 and an upper portion of the second isolation pattern 550 surrounding the portion of the through via 660 may be exposed over the third substrate 510.

The third bonding layer 950 may be formed on the third substrate 510, the second isolation pattern 550 and the through via 660, and a planarization process may be performed on the third bonding layer 950 until the upper surfaces of the through via 660 and the second isolation pattern 550 are exposed so that the third bonding layer 950 may cover a sidewall of the second isolation pattern 550.

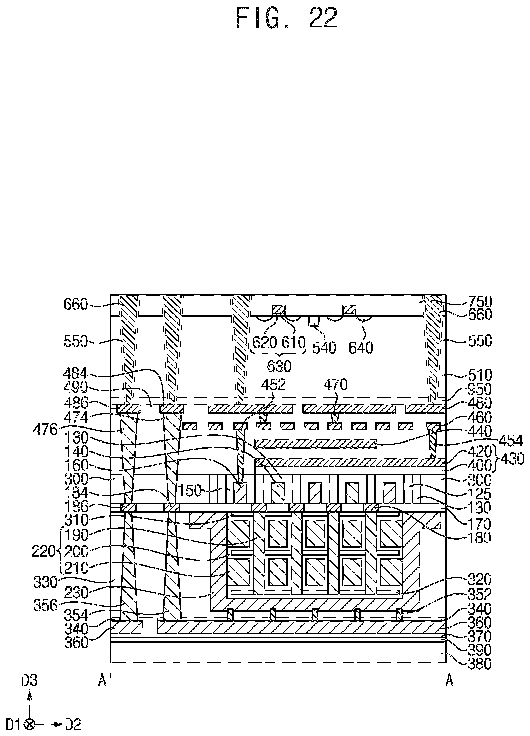

Referring to FIG. 22, processes substantially the same as or similar to those illustrated with respect to FIG. 15 may be performed.

Thus, the fourth substrate 1200 may be flipped, and the third bonding layer 950 may contact the fifth insulating interlayer 490 to be bonded thereto. The through via 660 and the second isolation pattern 550 covering the sidewall of the through via 660 may contact the upper surface of each of the fourth to sixth wirings 480, 484 and 486.

The fourth substrate 1200 and the second bonding layer 1210 may be removed by, e.g., a grinding process.

Referring to FIG. 18, processes substantially the same as or similar to those illustrated with respect to FIG. 16 and FIG. 1 may be performed to complete the fabrication of the semiconductor device.

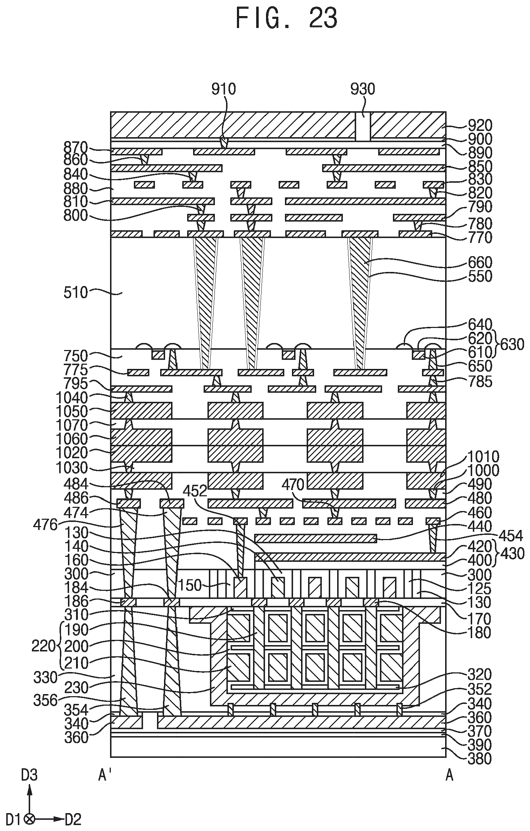

FIG. 23 is a cross-sectional view illustrating a semiconductor device in accordance with example embodiments, which may correspond to FIG. 1. This semiconductor device may be substantially the same as or similar to that of FIG. 1, except for some elements, and thus repeated explanations are omitted herein.

Referring to FIG. 23, for example, the peripheral circuit pattern including a transistor may be disposed beneath the third substrate 510, and may be arranged to face downwardly in the third direction D3.

A bonding layer structure including a bonding pad structure may be disposed between a portion of the wiring structure on the memory cells and a portion of the wiring structure under the peripheral circuit pattern.

The bonding layer structure may include fourth and fifth bonding layers 1030 and 1070 stacked in the third direction D3, and the bonding pad structure may include first and second bonding pads 1020 and 1060 stacked in the third direction D3.

In example embodiments, the first bonding pad 1020 may include a lower portion having a first width and an upper portion having a second width greater than the first width, and the second bonding pad 1060 may include a lower portion having a third width and an upper portion having a fourth width less than the third width. In an example embodiment, the second width of the upper portion of the first bonding pad 1020 may be substantially the same as the third width of the lower portion of the second bonding pad 1060, however, the inventive concept is not limited thereto.

Each of the first and second bonding pads 1020 and 1060 may include a metal, e.g., copper, and each of the fourth and fifth bonding layers 1030 and 1070 may include, e.g., silicon carbonitride, silicon oxide, etc.

An eighth via 1000 and a fourteenth wiring 1010 may be disposed between and contact the fourth wiring 480 and the first bonding pad 1020. A fifteenth wiring 775, a ninth via 785, a sixteenth wiring 795, a tenth via 1040 and a seventeenth wiring 1050 may be sequentially stacked between and contact the eighth contact plug 650 and the second bonding pad 1060.

A portion of the wiring structure for transferring electrical signals to the peripheral circuit pattern may be disposed on the third substrate 510. For example, the seventh to thirteenth wirings 770, 790, 810, 830, 850, 870 and 920 and the second to seventh vias 780, 800, 820, 840, 860 and 910 may be disposed on the third substrate 510, and the eighth insulating interlayer 880, the third etch stop layer 900 and the tenth insulating interlayer 930 covering the seventh to thirteenth wirings 770, 790, 810, 830, 850, 870 and 920 and the second to seventh vias 780, 800, 820, 840, 860 and 910 may be disposed on the third substrate 510.

The through via 660 may extend through the third substrate 510 and an upper portion of the sixth insulating interlayer 750, and may contact the seventh and fifteenth wirings 770 and 775. The second isolation pattern 550 may cover the sidewall of the through via 660. FIG. 23 shows a single through via 660 in the second isolation pattern 550, however, the inventive concept is not limited thereto, and similar to that of FIG. 17, a plurality of through vias 660 may be disposed in the second isolation pattern 550.

In the semiconductor device, the signal line may be disposed under and over the third substrate 510, and the power line may be disposed over the third substrate 510.

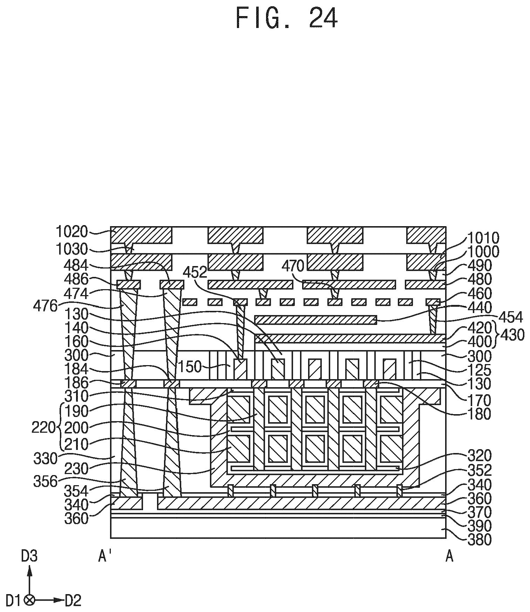

FIGS. 24 to 26 are cross-sectional views illustrating a method of manufacturing a semiconductor device, particularly, the semiconductor device of FIG. 23. This method may include processes substantially the same as or similar to those illustrated with respect to FIGS. 2 to 16 and FIG. 1, and thus repeated explanations are omitted herein.

Referring to FIG. 24, processes substantially the same as or similar to those illustrated with respect to FIGS. 2 to 11 may be performed.

However, an eighth via 1000 and a fourteenth wiring 1010 may be further formed on the fourth wiring 480, and may be covered by the fifth insulating interlayer 490.

A fourth bonding layer 1030 and a first bonding pad 1020 may be formed on the fifth insulating interlayer 490 and the fourteenth wiring 1010. In example embodiments, the first bonding pad 1020 may be formed by a dual damascene process, and thus may be formed to include a lower portion and an upper portion having a width greater than that of the lower portion.

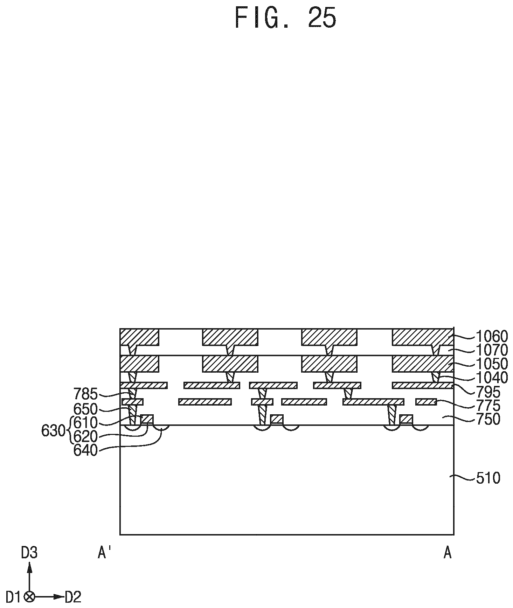

Referring to FIG. 25, the gate structure 630 may be formed on the third substrate 510, and the impurity regions 640 may be formed at upper portions, respectively, of the third substrate 510 adjacent to the gate structure 630 to form a transistor.

The eighth contact plug 650 may be formed to contact the upper surface of the impurity region 640, a fifteenth wiring 775, a ninth via 785, a sixteenth wiring 795, a tenth via 1040 and a seventeenth wiring 1050 may be formed, and the sixth insulating interlayer 750 may be formed to cover the fifteenth wiring 775, the ninth via 785, the sixteenth wiring 795, the tenth via 1040 and the seventeenth wiring 1050.

A fifth bonding layer 1070 and a second bonding pad 1060 may be formed on the sixth insulating interlayer 750 and the seventeenth wiring 1050. In example embodiments, the second bonding pad 1060 may be formed by a dual damascene process, and thus may be formed to include a lower portion and an upper portion having a width greater than that of the lower portion.

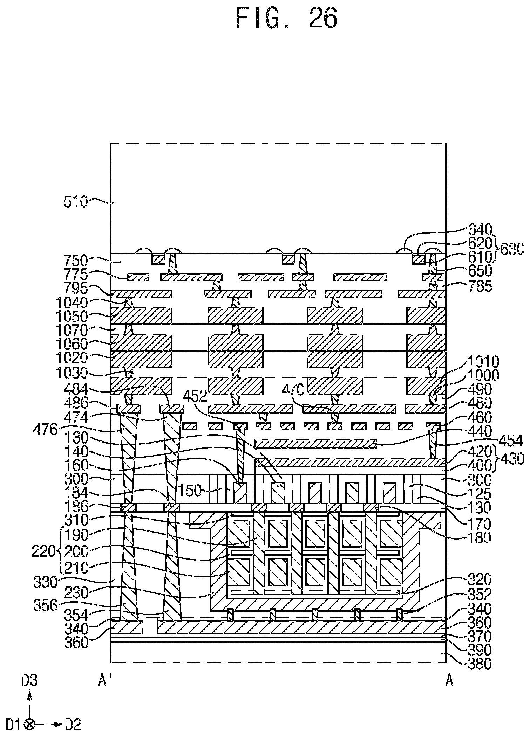

Referring to FIG. 26, the third substrate 510 may be flipped, and the fifth bonding layer 1070 and the second bonding pad 1060 may contact the fourth bonding layer 1030 and the first bonding pad 1020, respectively, on the second substrate 380 to be bonded thereto.

That is, structures on the third substrate 510 and structures on the second substrate 380 may be bonded to each other by a hybrid copper bonding (HCB) process.

Referring to FIG. 23 again, the second isolation pattern 550 and the through via 660 may be formed inside and through the third substrate 510 and through the upper portion of the sixth insulating interlayer 750 to contact an upper surface of the fifteenth wiring 775, and the seventh to twelfth wirings 770, 790, 810, 830, 850 and 870 and the second to sixth vias 780, 800, 820, 840 and 860 may be formed in the eighth insulating interlayer 880.

The ninth insulating interlayer 890, the third etch stop layer 900, the seventh via 910, the thirteenth wiring 920 and the tenth insulating interlayer 930 may be formed on the eighth insulating interlayer 880 and the twelfth wiring 870 to complete the fabrication of the semiconductor device.

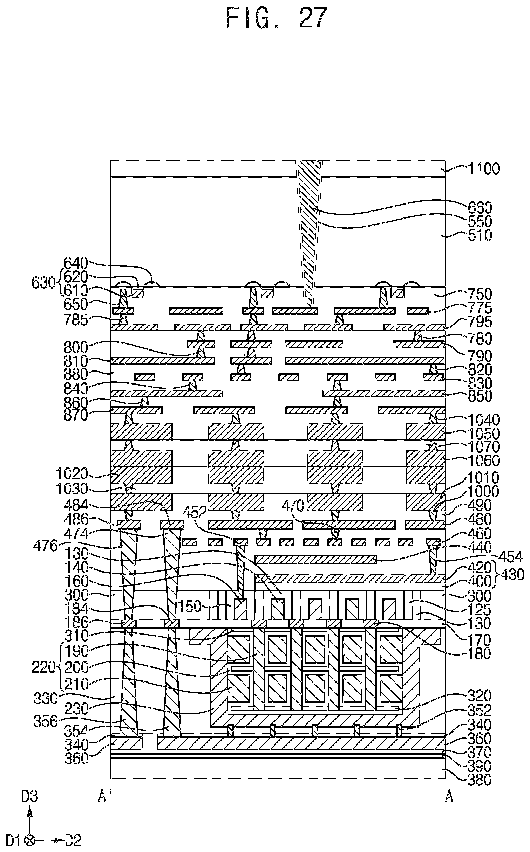

FIG. 27 is a cross-sectional view illustrating a semiconductor device in accordance with example embodiments, which may correspond to FIG. 23. This semiconductor device may be substantially the same as or similar to that of FIG. 23 except for some elements, and thus repeated explanations are omitted herein.

Referring to FIG. 27, both of the signal line and the power line may be disposed between the memory cells and the peripheral circuit pattern.

Thus, unlike those of FIG. 23, the eighth to thirteenth wirings 790, 810, 830, 850, 870 and 920 and the second to seventh vias 780, 800, 820, 840, 860 and 910 may not be disposed on the third substrate 510, but may be disposed under the third substrate 510, particularly, under the sixteenth wiring 795.

An eleventh insulating interlayer 1100 may be disposed on the third substrate 510, and the second isolation pattern 550 and the through via 660 may extend inside and through the eleventh insulating interlayer 1100, the third substrate 510 and the upper portion of the sixth insulating interlayer 750 and contact an upper surface of the fifteenth wiring 775. The through via 660 may be electrically connected to an outer input/output device, and may transfer input/output signals.

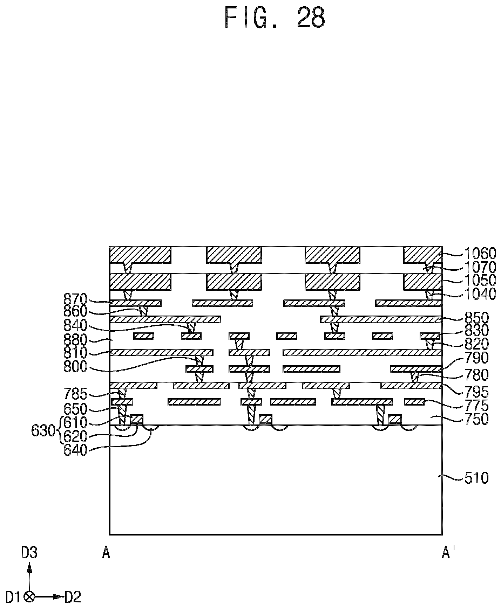

FIG. 28 is a cross-sectional view illustrating a method of manufacturing a semiconductor device, particularly, the semiconductor device of FIG. 27. This method may include processes substantially the same as or similar to those illustrated with respect to FIGS. 24 to 46 and FIG. 23, and thus repeated explanations are omitted herein.

Referring to FIG. 28, processes substantially the same as or similar to those illustrated with respect to FIGS. 24, 25 and 23 may be performed.

However, the second to sixth vias 780, 800, 820, 840 and 860, the tenth via 1040, the eighth to twelfth wirings 790, 810, 830, 850 and 870 and the seventh wiring 1050, and the eighth insulating interlayer 880 covering the second to sixth vias 780, 800, 820, 840 and 860, the tenth via 1040, the eighth to twelfth wirings 790, 810, 830, 850 and 870 and the seventh wiring 1050 may be formed on the sixteenth wiring 795 and the sixth insulating interlayer 750. The fifth bonding layer 1070 and the second bonding pad 1060 may be formed on the eighth insulating interlayer 880.

The second isolation pattern 550 and the through via 660 may not be formed.

Referring to FIG. 27 again, processes substantially the same as or similar to those illustrated with respect to FIG. 26 may be performed.

Thus, the third substrate 510 may be flipped, and the fifth bonding layer 1070 and the second bonding pad 1060 may contact the fourth bonding layer 1030 and the first bonding pad 1020, respectively, on the second substrate 380 to be bonded thereto.

An eleventh insulating interlayer 1100 may be formed on the third substrate 510, and the second isolation pattern 550 and the through via 660 may be formed through the eleventh insulating interlayer 1100, the third substrate 510 and the upper portion of the sixth insulating interlayer 750 to contact the upper surface of the fifteenth wiring 775, so that the fabrication of the semiconductor device may be completed.

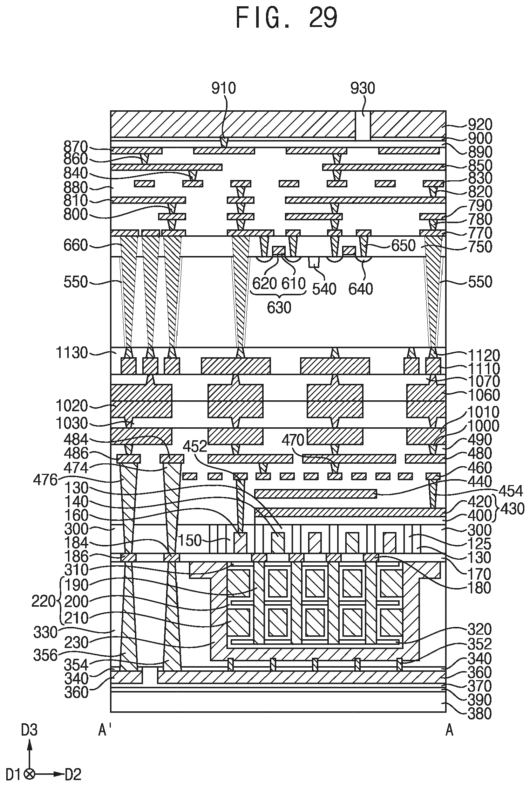

FIG. 29 is a cross-sectional view illustrating a semiconductor device in accordance with example embodiments, which may correspond to FIG. 17. This semiconductor device may be substantially the same as or similar to that of FIG. 17 except for some elements, and thus repeated explanations are omitted herein.

Referring to FIG. 29, the eighth via 1000 and the fourteenth wiring 1010 may be disposed on the fourth wiring 480, and may be covered by the fifth insulating interlayer 490.

The fourth and fifth bonding layers 1030 and 1070 and the first and second bonding pads 1020 and 1060 may be disposed on the fifth insulating interlayer 490 and the fourteenth wiring 1010.

Additionally, an eighteenth wiring 1110 and an eleventh via 1120 may be disposed between the third substrate 510 and the fifth bonding layer 1070 and the second bonding pad 1060, and a twelfth insulating interlayer 1130 may cover the eighteenth wiring 1110 and the eleventh via 1120. The eleventh via 1120 may contact a lower surface of the through via 660, and may be electrically connected thereto.

The semiconductor device may be manufactured by bonding the second substrate 380 on which the memory cells and the wiring structure are disposed and the third substrate 510 on which the peripheral circuit pattern is disposed through an HCB process.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
a capacitor spaced apart from a first substrate in a first direction, wherein the first direction is substantially perpendicular to an upper surface of the first substrate;
a channel on the capacitor;
a gate electrode at least partially overlapping the channel in a second direction, wherein the second direction is substantially parallel to the upper surface of the first substrate;
a bit line structure on the gate electrode and the channel;
a first wiring structure on the bit line structure;
a bonding pad structure on the first wiring structure;
a second wiring structure on the bonding pad structure;
a second substrate on the second wiring structure;
a transistor with impurity regions in the second substrate;
a third wiring structure on the second substrate;
an isolation pattern extending through opposite sides of the second substrate; and
a through via extending inside the isolation pattern.

2. The semiconductor device according to claim 1, further comprising a bonding layer structure on a sidewall of the bonding pad structure, the bonding layer structure including silicon carbonitride or silicon oxide.

3. The semiconductor device according to claim 2, further comprising an insulating interlayer on the bonding layer structure and on the second wiring structure,
wherein the isolation pattern and the through via extend into an upper portion of the insulating interlayer.

4. The semiconductor device according to claim 1, further comprising a plurality of through vias spaced apart from each other in the second direction, the through via being one of the plurality of through vias.

5. The semiconductor device according to claim 1, wherein a width of the through via increases as a distance in the first direction from the first substrate increases.

6. The semiconductor device according to claim 1, wherein the third wiring structure includes a wiring configured to apply an input/output signal.

7. The semiconductor device according to claim 1, wherein the third wiring structure includes a power line.

8. The semiconductor device according to claim 1, further comprising a plate electrode on a surface of the capacitor facing the first substrate and a sidewall of the capacitor.

9. The semiconductor device according to claim 8, further comprising:
a first conductive pad between and contacting the channel and the capacitor;
a second conductive pad spaced apart from the first conductive pad in the second direction, wherein the first conductive pad is at a same distance from the first substrate as the first conductive pad;
a wiring between the plate electrode and the first substrate;
a first contact plug contacting a surface of the plate electrode facing the first substrate and a surface of the wiring facing the capacitor; and
a second contact plug contacting the surface of the wiring facing the capacitor and a surface of the second conductive pad facing the first substrate, a width of the second contact plug decreasing as a distance in the first direction from the first substrate increases.

10. The semiconductor device according to claim 9, further comprising a third contact plug contacting a surface of the second conductive pad facing the second substrate and a portion of the first wiring structure, a width of the third contact plug increasing as a distance in the first direction from the first substrate increases.

11. A semiconductor device comprising:
a capacitor spaced apart from a first substrate in a first direction, wherein the first direction is substantially perpendicular to an upper surface of the first substrate;
a channel on the capacitor;
a gate electrode at least partially overlapping the channel in a second direction, wherein the second direction is substantially parallel to the upper surface of the first substrate;
a bit line structure on the gate electrode and the channel;
a first wiring structure on the bit line structure;
a bonding pad structure on the first wiring structure;
a second wiring structure on the bonding pad structure;
a second substrate on the second wiring structure;
a transistor with impurity regions in the second substrate;
an isolation pattern extending through the second substrate; and
a through via extending through opposite sides of the isolation pattern,
wherein the through via is connected to an input/output device and configured to transfer an input/output signal generated from the input/output device.

12. The semiconductor device according to claim 11, wherein the through via includes a protrusion portion that protrudes from a surface of the second substrate facing away from the first substrate, and
wherein the semiconductor device further comprises an insulating interlayer on the second substrate and on a sidewall of the protrusion portion of the through via.

13. The semiconductor device according to claim 11, further comprising a bonding layer structure on a sidewall of the bonding pad structure, the bonding layer structure including silicon carbonitride or silicon oxide.

14. The semiconductor device according to claim 11, wherein the second wiring structure includes a signal line and a power line.

15. The semiconductor device according to claim 11, further comprising a plate electrode on a surface of the capacitor facing the first substrate and a sidewall of the capacitor.
